Europäisches Patentamt

(19) European Patent Office

Office européen des brevets

(11) Publication number: **0 165 547**
**A2**

## (12) EUROPEAN PATENT APPLICATION

(21) Application number: **85107228.0**

(22) Date of filing: **13.06.85**

(51) Int. Cl.⁴: **H 01 L 21/28**
**H 01 L 21/225**

(30) Priority: **21.06.84 US 622949**

(43) Date of publication of application:
**27.12.85 Bulletin 85/52**

(84) Designated Contracting States:
**DE FR GB**

(71) Applicant: **International Business Machines Corporation**
**Old Orchard Road**
**Armonk, N.Y. 10504(US)**

(72) Inventor: **Rubloff, Gary Wayne**
**16 Nightingale Road**
**Katonah, NY 10536(US)**

(72) Inventor: **Wittmer, Marc Francis**
**Box 171, Colonel Greene Rd**
**Yorktown Hgts, NY 10598(US)**

(74) Representative: **Hobbs, Francis John**
**IBM United Kingdom Patent Operations Hursley Park**
**Winchester, Hants, SO21 2JN(GB)**

(54) A method of forming a shallow doped region in a semiconductor substrate.

(57) A shallow (not more than about 30nm deep) doped region (24) is formed in a semiconductor substrate (10) by depositing at least two overlayers (12, 14) on the top surface of the semiconductor substrate, one (14) of the overlayers containing metal atoms. The overlayers are such that a metal compound is formed from the metal atoms in one (14) of the overlayers and atoms from another one (12) of the overlayers when the multilayered structure is annealed at a temperature less than 700°C. At least one (12) of the overlayers contains atoms to be introduced as a dopant into the substrate.

When the multilayer structure is annealed at a temperature less than 700°C the metal compound is formed and releases the atoms to be introduced into the substrate. This produces an interface (18) which moves towards the substrate and pushes the released atoms by the snowplow effect towards the substrate. The annealing is continued for a time sufficient to move the interface (18) to the top surface of the substrate to push the released atoms into the body of the substrate.

FIG. 2

FIG. 3

FIG. 4

## A METHOD OF FORMING A SHALLOW DOPED
## REGION IN A SEMICONDUCTOR SUBSTRATE

This invention relates to a method of forming a shallow doped region in a semiconductor substrate.

Semiconductor devices of very large scale integration (VLSI) have been developed by scaling down dimensions of the individual circuit elements. The trend in the near future is toward feature lengths below 1 micrometer. The lateral reduction of submicron structures has given rise to new problems, among them the most prominent one being the short channel effect in metal oxide semiconductor (MOS) field effect transistors. This undesirable effect can be eliminated by scaling down voltage and device size in all three dimensions, where not only the lateral dimensions (such as contact areas, gate lengths, and gate widths), but also the vertical dimensions (such as junction depths and thickness of gate oxides), have to be reduced.

While the necessity for providing shallow doped regions in semiconductors has been recognised, no suitable technique has been provided for providing very shallow doped regions at low temperatures. For example, conventional techniques for doping impurities into silicon require high temperatures above 900°C, either for thermal diffusion or for annealing out the damage induced by ion implantation. For doping by ion implantation, the post-annealing at high temperatures is necessary to remove the structural damage caused by ion implantation and to insure that the dopants introduced into the semiconductor are electrically active. These high temperature processes, however, in general cause unnecessary redistribution of impurities and degradation of shallow junction structures. Therefore, a low temperature doping method if preferable.

A suitable low temperature method must be one which provides very shallow doped regions having depths of the order of a few hundred angstroms (tens of nanometers), or less, at temperatures less than 700°C (or preferably 500°C) and in which there is minimal consumption of the substrate during formation of the doped region.

To solve these problems, the present invention, dopes a substrate by the introduction of a dopant from an overlying layer, where metal compound formation in the overlying layer produces an interface which moves towards the substrate and pushes the dopant in front of it. This is the so-called "snowplow" effect wherein a dopant can be piled up in front of the interface by its growth motion. The effect is known in the art and is caused by rejection of the dopant by the growing metal compound, due to enhanced diffusion of the dopant during metal compound formation. Thus, the dopant originates in a layer overlying the substrate and is pushed into the substrate to form a very shallow doped region in the substrate. This can proceed at a very low temperature.

References which generally deal with the redistribution of implanted dopants in a semiconductor by the snowplow effect include the following:

1.    I Chdomari et al, Appl. Phys. Lett. 38 (12), page 1015, June 15, 1981.

2.    M Wittmer et al, J Appl. Phys. 53 (10), page 6781, Oct. 1982.

3.    M Wittmer et al, J Appl. Phys. 49 (102, page 5827, Dec. 1978.

4.    J B Bindell et al, IEEE Trans. on Electron Devices, Vol. ED-27, No 2, page 420, Feb. 1980.

5.    M Wittmer et al, Physical Review B, Vol 29, No 29, No. 4, page 2010, Feb. 15, 1984.

6.    I Ohdomari et al, Thin Solid Films, 89, page 349, 1982.

**0165547**

As noted in reference 1, the snowplow effect has been used to redistribute implanted substrate dopants during the growth of different types of compounds. For example, during thermal growth of $SiO_2$, dopant redistribution in the vicinity of the $SiO_2$-Si interface occurs. A similar effect occurs during the growth of near-noble metal silicides as discussed in others of these cited references. Such techniques have been suggested as a way to provide a low temperature process of redistributing dopants in a semiconductor substrate. However, the dopants were initially introduced in the substrate by ion implantation, which requires a high temperature annealing step to produce electrically active dopants and to remove structural damage. Consequently, the complete device-forming process is one which requires high temperatures.

The following references describe the introduction of a dopant into an underlying semiconductor substrate where the dopant originates in an overlying layer.

7.   US-A-4,274,892.

8.   B Studer - Solid State Electronics, Vol. 23, page 1181 (1980).

9.   US-A-4,356,622

In references 7 and 9, a high temperature process is used in which dopants are introduced into a substrate by an oxidation step. These high temperatures are similar to those used in conventional diffusion techniques, where it has been believed that dopants such as As and P would not be introduced into a silicon substrate unless high temperatures were used.

In reference 8, a doped metal layer is deposited directly on the silicon substrate and subsequently a metal silicide is formed with the substrate. This compound formation causes the diffusion of dopants from the metal layer into the underlying silicon layer, increasing the dopant concentration near the silicide silicon interface. However, the substrate itself is consumed to an excessive degree during this compound formation process, which is not suitable for providing very shallow doped regions for use in VLSI.

Thus, while the prior art describes the use of the snowplow effect to redistribute already present dopants, and the diffusion of dopants from an overlying layer into a silicon substrate, no teaching is suggested of a technique for making very shallow doped regions in a substrate at low temperatures, and wherein the substrate is not consumed during production of the doped regions, the doped regions being less than a few hundred angstroms in depth.

The present invention seeks to provide a relatively low temperature process for forming a very shallow doped region in a substrate.

A method of forming a shallow doped region in a semiconductor substrate, comprises, in accordance with the invention, the steps of:

forming a multilayered structure by depositing at least two overlayers on the top surface of the semiconductor substrate, one of the overlayers containing metal atoms, the overlayers being such that a metal compound is formed from said metal atoms and atoms from another one of the overlayers when the multilayered structure is annealed at a temperature less than 700°C, and at least one of the overlayers containing atoms to be introduced as a dopant into the substrate; and

annealing the multilayer structure at a temperature less than 700°C to form said metal compound, the formation of said metal compound releasing the atoms to be introduced into the substrate and producing an interface which moves towards the substrate and pushes the released atoms by the snowplow effect towards the substrate, the annealing being performed for a time sufficient to move said interface to the top surface of the substrate to push the released atoms into the body of the substrate a distance not exceeding 30nm from the top surface of the substrate.

This invention involves the provision of overlayers on a substrate, and the reaction of these overlayers to produce a metal compound, there being a snowplow effect to push dopants in one or more of the overlayers into the substrate to create a very shallow doped region therein, the formation of the metal compound being at relatively low temperatures. The shallow doped region can be used to form a p-n junction in a semiconductor, to adjust a barrier height, or to provide contacts (such as ohmic contacts) to a doped semiconductor. Devices such as bipolar and field effect transistors, Schottky barrier diodes, and contacts can be formed by this technique, which is characterised by the provision of a doped region of about 30nm or less in depth, and the provision of such a doped region at a temperature less than 700°C. Preferably, the depth of the doped region is less than about 25nm, while the low temperature is less than 500°C.

The overlayers which are used for forming the metal compound are chosen to form such a compound at a temperature less than 700°C, and the compound is chosen to be one which will exhibit a snowplow effect to such an extent that dopants in one or more of the compound forming overlayers will be released and pushed, or snowplowed, into the substrate. As an example, this technique has been used to produce very shallow doped regions in a single crystal silicon semiconductor substrate, where the snowplow effect was due to the formation of a metal silicide compound, the interface of the growing silicide region being used to push dopants into the silicon substrate.

Both n- and p-type doped regions can be produced in a substrate (which may also be doped n- or p-type) by this technique, and the dopant concentration can be varied in accordance with the amount of dopant present in the overlayers and in the amount of time/temperature used to produce the metal compound.

How the invention can be carried out will now be described by way of example, with reference to the accompanying drawings, in which:-

FIGS. 1-5 represent successive steps in a process for providing very shallow doped regions in a substrate, which can be undoped, or doped (n- or p-type);

FIG. 6 illustrates the production of very shallow doped regions in a bipolar transistor; and

FIG. 7 illustrates the production of very shallow doped regions in a field effect transistor.

In a general sense, a plurality of overlayers is deposited on a substrate in which a very shallow doped region is to be created. These overlayers are chosen to be layers which will form a metal compound when the structure comprising the substrate and the overlayers is annealed at a temperature below 700°C, and preferably below 500°C. The overlayers are further chosen to be such that the formation of the metal compound will produce an interface which moves through one of the layers in a direction towards the substrate, and which will release and push dopants from one or more of the overlayers towards and into the substrate. That is, when the interface between the growing metal compound and the substrate advances to and into the substrate, the dopants originating in the overlayers will be pushed into the substrate.

It has been discovered that metal compound formation can be achieved in such a manner that a significant snowplow effect will occur at relatively low temperatures to produce very shallow doped regions in substrates, where the doping concentration can be predetermined and can be high, for example, $10^{21}$ carriers/cm$^3$. Some suitable dopants are the n-type dopants As, Sb, and P, which generally require high temperatures (of the order of 1000°C) in order to diffuse into a substrate such as silicon, and p-type dopants such as B.

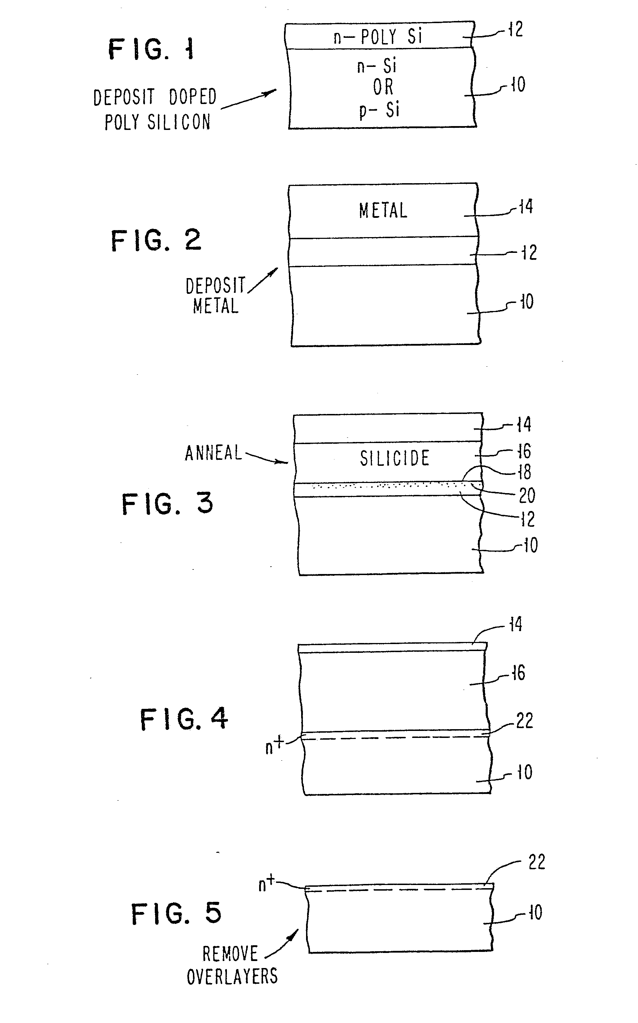

FIGS. 1-5 illustrate an embodiment of the invention wherein the substrate is of silicon and the metal compound is a metal silicide formed by annealing overlying metal and silicon layers. Thus, in FIG. 1, the substrate 10 is either an n-doped single crystal silicon layer, or a p-doped single crystal silicon layer. The substrate could, of course, be intrinsic material. A layer 12 of n-doped polycrystalline silicon (or amorphous silicon) is deposited on the substrate 10. This can be done in any of several well known ways, including low temperature chemical vapour deposition or ion implantation into only the layer 12. The n-type dopants in the polysilicon layer 12 can include, for instance, As, Sb and P, all of which are well known n-type dopants. If p-type doping were required, a dopant such as B would be used.

In FIG. 2, an overlying metal layer 14 is deposited on the polysilicon layer 12. For the formation of a metal silicide compound, the metal comprising layer 14 is preferably a noble or near-noble metal. Suitable metals include Pt, Pd, Ni, Ir, and Rh. Although the refractory metals (Ti, Ta, V) studied so far do not produce silicides having an appreciable snowplow effect, other refractory metal silicides may work well.

FIG. 3 illustrates an annealing step in which the polysilicon layer 12 and metal layer 14 chemically combine to form a silicide layer 16. This consumes the layers 12 and 14, and produces an interface 18 which moves towards the substrate. The annealing step is performed at temperatures just sufficiently high to promote the growth of the metal silicide in order to snowplow dopants 20 originally in the polysilicon layer 12. Of course, the dopants can be in the metal layer 14 instead of in the polysilicon layer 12, or can be present in both layers 12 and 14.

Annealing can be accomplished by any means including, for example, heating furnaces, flashlamps, and lasers. The important feature is that a metallic compound is formed, which is most easily achieved by an annealing (ie heating) step. Any low temperature step which forms a metallic compound with a moving interface could be used.

Doping of these layers 12, 14 can be accomplished by chemical vapour deposition of dopant-containing gaseous species together with silicon-containing gaseous species, or by physical vapour deposition (evaporation or sputtering) of dopant and silicon species, or by a combination of chemical and physical vapour deposition.

Doping of these layers 12, 14 can also be accomplished by ion implantation during or after deposition. This has the advantage that the dopants can be introduced at a desired depth in the polysilicon layer 12. By implanting near to the single crystal silicon interface (but entirely within the polysilicon layer 12), one can reduce the thickness of the polysilicon and metal layers, the resulting silicide layer, and the annealing time required for silicide formation and snowplow. Implantation gives good control of the doping level. Finally, because the implantation is only into the polysilicon layer 12, no implantation damage is created in the single crystal silicon 10; consequently, no high temperature annealing steps are needed, so the process remains a true low temperature doping technique.

FIG. 4 illustrates the continuation of the annealing step in which the metal layer 14 still remains, but the polysilicon layer 12 has been entirely consumed by the formation of the metal silicide 16. If the annealing is sufficient and the initial thicknesses of the layers 12 and 14 are chosen properly, the compound forming interface 18 will advance entirely through the polysilicon layer 12 and into the silicon substrate 10, producing a new silicide/silicon interface located a small distance inside the original single-crystal silicon substrate 10. When this occurs, a considerable portion of the dopants originally introduced into the polysilicon layer 12 will have been snowplowed ahead of the advancing silicide/silicon interface to form a doped region 22 in the substrate 10. The depth of the doped region 22 into the top surface of the substrate 10 is less than a few hundred angstroms, ie a few tens of nanometers, and is typically about 30nm, or less. The doping concentration in region 22 depends on the initial doping level of substrate 10 and the amount of dopant present in the overlayer 12.

The conductivity-type of the region 22 can be the same as that of the substrate 10, or opposite. Thus, a contact or a p-n junction can be created. For example, it is possible to dope the region 22 heavily (to an amount greater than $10^{20}$ carriers/cm$^3$) to create an ohmic contact. Varying degrees of dopant concentration can be produced in the shallow doped region 22, to provide rectifying contacts, Schottky barriers, etc.

If the metal 14 and silicide layer 16 are not chemically removed, they can be used as device contacts whose electrical properties can be chosen. Depending on the conduction type of the silicon substrate 10 and the dopant impurity of the polysilicon 12, one can form either low resistance Ohmic contacts (n-poly on n-Si or p-poly on p-Si) or a shallow p-n junction (n-poly on p-Si or p-poly on n-Si). If the doping of the polysilicon 12 is low, so that the amount of snowplowed dopant is reduced, then one can form a Schottky diode with electrical characteristics which are adjustable within a certain range according to the actual doping level.

In such cases, the polysilicon layer 12 can be delineated prior to the metal deposition in order to obtain a self-aligned Ohmic contact or p-n junction. In addition, the silicide overlayer 16, which has a low resistivity, can be patterned to form part of the interconnect metallization.

It should be noted, that similar results can be obtained by doping the deposited metal layer 14 instead of using a doped polysilicon layer 12 and by using amorphous silicon in place of the polysilicon layer.

If desired, the remaining metal 14 and compound 16 may be chemically removed from the surface of the single crystal silicon substrate 10, leaving the very thin doped region 22 at the surface of the substrate 10. Other processing steps, including the process described here as well as other semiconductor device processes, can subsequently be employed to fabricate further device layers and structures, such as transistors and multilayer and superlattice devices.

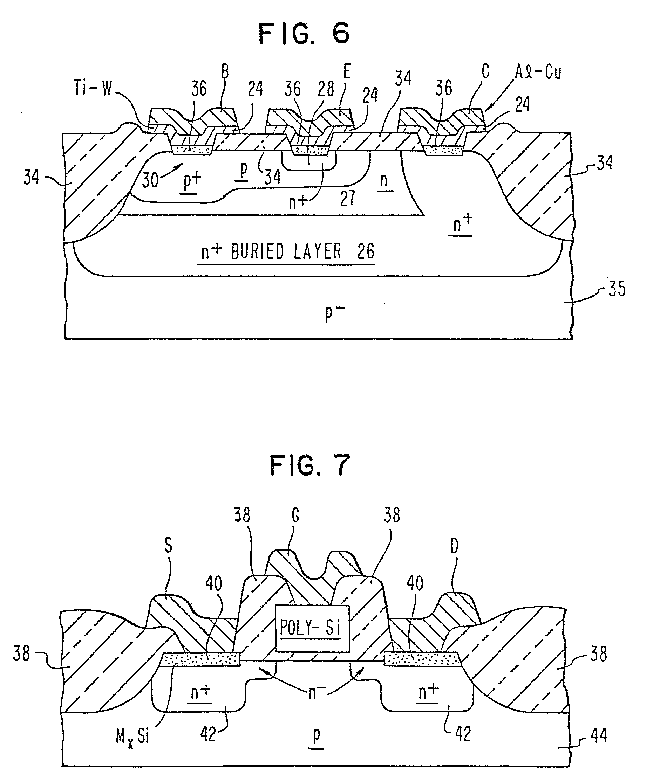

In the example of FIGS. 1-5, two layers 12, 14 were used to produce the metal silicide whose moving interface snowplowed dopants into the substrate. However, more than two layers (materials) can be used to produce the metal compound, and the compound need not be a silicide. Noble and near-noble metal silicides are advantageous, however, as these compounds can be formed at very low temperatures, and will have a sufficient snowplow effect to provide efficient doping of the substrate. In addition to the unique advantages of forming metal silicide compounds, these compounds can be used to reduce the resistance of polysilicon lines, and for interconnects and contacts, as will be seen with respect to FIGS. 6 and 7. Still further, the technique illustrated in FIGS. 1-5 will work with silicon substrates 10 of different crystallographic structures, such as (111) and (100).

In the practice of this technique, it has been found that a high percentage (greater than 50%) of the snowplowed dopants are electrically active dopants in the substrate 10. This result occurs even at low temperatures (such as 250°C), in contrast with the high temperature post-annealing step used to produce electrically active dopants when the dopants are introduced by ion implantation. This success at low temperatures is also surprising, considering that these same dopants (As, Sb, P, B, etc) require high temperatures to be incorporated into the same substrate, when introduced by diffusion or ion implantation.

The snowplow effect can be used to introduce dopants into the top surface of the substrate 10 to a controlled, shallow depth. Thus, if there are imperfections (such as dislocations, etc) or trace impurities in the first few layers of the substrate, the snowplow effect can be used to drive the dopants past these imperfections and impurities into the body of the substrate. In this manner, a very shallow doped region of high integrity and uniformity can be formed at a desired depth in the substrate 10.

Metal layer 14 is of a minimum thickness to insure that the entire thickness of layer 12 is consumed during metal compound formation.

Typically, the thickness of metal layer 14 is greater than that required
to consume all of layer 12, and also to insure that the growing interface extends into the substrate 10. As was noted, this insures that the
dopants are snowplowed past any slight impurities or imperfections that
would exist at the surface of the substrate in order to create the
shallow doped region in the body of the substrate. Of course, if the
top surface of the substrate is adequate, the silicide boundary can be
made to stop at the beginning of the substrate, if desired (such as to
prevent any consumption of the single crystal silicon substrate 10).

During introduction of the impurities using the snowplow effect,
the thicknesses of the layers 12 and 14 are initially determined with
respect to the silicide phase which will be formed, in order to have the
silicide interface extend the desired amount into the substrate 10. The
annealing conditions (temperature, time) are then set to determine where
the moving interface will stop. If metal layer 14 is entirely consumed,
the fact that the annealing continues will not alter the depth of the
silicide interface. Thus, an initial determination of the proper
thicknesses of layers 12 and 14 provides a good control over the final
location of the silicide interface.

As was mentioned previously, the amount of doping in the overlayers, and their thicknesses, can be used to determine the amount of
dopant introduced into the substrate. As an example, if it is assumed
that 10% of the dopants in the layer 12 are snowplowed into substrate
10, and it is desired to dope the substrate to a level of about $10^{18}$
carriers/cm³ into a 10nm deep region, then the doping in the polysilicon
layer 12 will be about $2 \times 10^{18}$ carriers/cm³. This doping level can be
produced in a 50nm thick layer 12 by CVD doping or by implanting at a
dosage of $10^{13}$/cm².

The snowplow effect can be used to increase the doping level of the
substrate by several orders of magnitude, or to initially dope intrinsic
material. If the substrate is initially doped, it can be doped de-
generately in a shallow region by the snowplow effect. Also, if the dopant level in the polysilicon layer 12 is increased to greater that $10^{20}$ carriers/cm³, then a doping level of greater that $10^{18}$ can be produced in the substrate.  Generally, the polysilicon layer 12 is about 30nm thick, and can be, for example, 10-50nm thick.  Thus, the dopant level in layer 12 can be changed to smoothly change the dopant concentration of shallow region 22, to any desired amount.

While single crystal silicon has been mentioned as a suitable substrate 10, this invention will work with other semiconductor substrates, such as Ge.

Still further, metal silicides are not the only metallic compounds which can be formed at very low temperatures and which will exhibit a snowplow effect.  The metal layer 14 may be combined with a doped Ge layer 12 to form germanide compounds 16.  Also, the metal layer 14 may be reacted with compound semiconductors (III-V or II-VI) to form new compounds combining metal and semiconductor constituents.  For example, layer 12 can be GaAs while metal layer 14 is Pd.  During the formation of a metallic compound of Pd and Ga the As in the GaAs layer would be freed to act as a dopant that would be pushed into the substrate 10. The chemistry of Pd on GaAs is described in more detail by P Oelhafen et al in J. Vac. Sci. Technol. B, 1 (3), page 588, July/September 1983.  Pt is another suitable metal that can be used for layer 14 when layer 12 is GaAs.  The chemistry of Pt and GaAs is described by C Fontaine et al in Appl. Phys. 54, (3), page 1404, March 1983.  When these materials are used, it is possible to free As from the GaAs layer, where the freed As would be snowplowed into the substrate 10.

From the foregoing, it is apparent that the dopants which are to be snowplowed into the substrate can be present as dopants in either or both of the layers 12 and 14, or can be a primary constituent of the material comprising one of these layers (such as As which is stoichiometrically joined with Ga to form GaAs).

In the practice of this invention, a layer (such as polysilicon or amorphous silicon layer 12) is provided which is consumed during the metal compound-forming step. This is important to move the interface of the metal compound close to or into the top surface of the substrate 10, and to prevent too much of the substrate 10 from being consumed. For example, if layer 12 were not used and a metal layer were deposited directly onto the silicon substrate 10, annealing would cause a reaction between the metal layer and the silicon substrate, and would consume a large amount of the substrate (comparable to the metal layer 14 thickness during the introduction of dopants into the substrate). This is undesirable, and is one of the problems noted with respect to reference 8. Further, while metal silicides are particularly good metal compounds to be used in the practice of this invention, not all metal silicides will work. Noble metal and near-noble metal silicides appear to work well and form compounds at low temperatures. On the other hand, refractory metal silicides require higher temperatures of formation, and do not exhibit significant snowplow effects (see reference 5). Even though the solubility of the same dopant in these different types of silicides may be similar, the refractory metal silicides do not snowplow dopants to the extent that the noble metal and near-noble metal silicides do. This may be explained somewhat by the mechanisms covering the growth of metal silicides, as is described in the aforementioned reference 5.

FIGS. 6 and 7 show general diagrams of two devices in the production of which the process of the present invention has been used. While the buried collector transistor structure of FIG. 6 and the field effect device of FIG. 7 are chosen as representative examples, it will be appreciated that the present invention could be used to make other structures and devices.

In FIG. 6, base, emitter, and collector contacts (B, E, and C, respectively) are shown which are comprised of a metal such as Al-Cu. A layer 24 of Ti-W is used as a diffusion barrier. In this n-p-n structure, the collector region is comprised of the $n^+$ buried layer 26 which is a contact to an n region 27 while the emitter is comprised of an $n^+$ region 28. The base is comprised of a $p^+$ region 30, formed as a portion of the p-type region 32. Insulating regions 34 provide electrical isolation between adjacent devices, and between the emitter, base and collector contacts. The substrate is a p-type silicon wafer 35.

PtSi regions 36 are used to make contact to the underlying doped regions of this device. In order to make the device of FIG. 6, these PtSi compounds can be used to snowplow dopants in order to form low resistivity contacts to region 28 and a shallow doped region 30.

FIG. 7 shows a field effect transistor comprising a source contact S, a gate contact G, and a drain contact D. Insulating regions 38, such as $SiO_2$, are located between adjacent devices, between adjacent metal contacts, and beneath the gate contact G. Metal silicide contacts 40, designated $M_x Si$, make electrical contact to the source and drain $n^+$ regions 42. The substrate 44 is p-silicon.

This invention can be used to make shallow $n^+$ regions 42 beneath the metal silicide 40. For example, regions 42 can be n-type, but of a lesser dopant concentration than the portions of these regions immediately below the silicide 40. During formation of the silicide 40, n-dopants will be snowplowed into the top surface of regions 42, in order to produce $n^+$ doping. In this way, an ohmic contact can be provided between the metal silicide layer 40 and the snowplowed doped region immediately below it.

While binary compounds have been described for use in this invention, it will be understood by those skilled in the art that multiphase compounds such as ternary and higher order compounds can also be used. Further, suitable metal silicides for use in this invention include silicides of metals of the transition series, and rare earth metal silicides.

Noble and near-noble metals, such as Pt, Pd, Ir, Rh, Os, Ru, and Ni may be preferred, since they form compounds such as silicides at low temperatures. For example, Pt and Pd will form silicides at approximately 250°C, while most refractory metals form silicides at higher temperatures (500-700°C). Also, for the metals studied thus far, the noble and near-noble silicides exhibit a stronger snowplow effect than do the refractory metal silicides. However, it is believed that at least some refractory metals may provide silicides useful for the present invention, or other compounds which will exhibit an effective snowplow effect. Refractory metals, such as Cr and Ti, may be suitable. Rare earth metals can also be used, such as Er and Sm.

Si, Ge, and GaAs were mentioned as suitable materials for the overlayer 12. However, other materials can be chosen. For example, overlayer 12 can be comprised of a III-V material other than GaAs, such as InP. Other suitable materials for overlayer 12 include II-VI materials such as CdTe and ZnSe. Suitable metal layers with these III-V and II-VI materials are, for example, Pt and Pd.

In the practice of this invention, the dopant can be present as a dopant in an overlayer (such as p in polysilicon) or can be a primary constituent of the overlayer (such as As in GaAs). The element to be used to dope the substrate can also be present as a dopant in a III-V or II-VI material, such as a Zn dopant in GaAs. During metal compound formation between the metal and/or Ga and As, the Zn would be released and pushed into the substrate. This technique can be used to dope a substrate with any kind of dopant, or dopants to produce different types of devices, including light emitting diodes.

CLAIMS

1.   A method of forming a shallow doped region (22) in a semiconductor substrate (10), comprising the steps of:

forming a multilayered structure by depositing at least two overlayers (12, 14) on the top surface of the semiconductor substrate (10), one (14) of the overlayers containing metal atoms, the overlayers being such that a metal compound is formed from said metal atoms and atoms from another one (12) of the overlayers when the multilayered structure is annealed at a temperature less than 700°C, and at least one (12) of the overlayers containing atoms to be introduced as a dopant into the substrate; and

annealing the multilayer structure at a temperature less than 700°C to form said metal compound, the formation of said metal compound releasing the atoms to be introduced into the substrate and producing an interface (18) which moves towards the substrate and pushes the released atoms by the snowplow effect towards the substrate, the annealing being performed for a time sufficient to move said interface to the top surface of the substrate to push the released atoms into the body of the substrate a distance not exceeding 30nm from the top surface of the substrate.

2.   A method as claimed in claim 1, in which the overlayers are such that a compound is formed from said metal atoms and atoms of another element present in the overlayers when the overlayers are annealed at a temperature less than 500°C, and the multilayer structure is annealed at a temperature less than 500°C to form said compound.

3.   A method as claimed in claim 1 or claim 2, in which only two overlayers are deposited on the top surface of the substrate, the inner layer being comprised of a semiconductor material and the outer layer of a metal.

4.   A method as claimed in claim 3, in which the inner layer is comprised of polycrystalline or amorphous silicon, doped with the atoms to be introduced as a dopant into the substrate, and the outer layer is comprised of a metal which forms a silicide upon the annealing of the multilayer structure.

5.   A method as claimed in claim 4, in which the thickness of the outer layer is such that all the inner layer is consumed during formation of the silicide.

6.   A method as claimed in claim 3, in which the inner layer consists of germanium.

7.   A method as claimed in claim 3, in which the inner layer consists of GaAs, InP, CdTe or ZnSe.

8.   A method as claimed in any of claims 4 to 7, in which the metal-atom containing overlayer consists of Pd, Pt, Ni, Rh, Os, Ir, Cr, Co or Ru.

9.   A method as claimed in claim 3, in which the outer, metal layer contains the atoms to be introduced as a dopant into the substrate.

10.   A method as claimed in claim 1 or claim 2, in which the dopant atoms to be introduced into the substrate are a constituent of a compound which one of the overlayers is made of, and in which the formation of said metal compound from atoms present in the overlayers releases the atoms to be introduced into the substrate from the compound of which one of the overlayers is made.

11.   A method as claimed in claim 10, in which the compound of which one of the overlayers is made is a Group III-V or Group II-VI compound.

12.   A method as claimed in any preceding claim, in which the substrate is a single crystal silicon layer.

13.  A method as claimed in any preceding claim, in which the atoms to be introduced as a dopant into the substrate are B, P, As or Sb atoms.

14.  A method as claimed in any preceding claim, including removing the overlayers from the substrate when the annealing has been completed.

**FIG. 1**

DEPOSIT DOPED
POLY SILICON

n—POLY Si — 12

n– Si
OR
p– Si — 10

**FIG. 2**

DEPOSIT
METAL

METAL — 14

— 12

— 10

**FIG. 3**

ANNEAL

— 14
SILICIDE — 16
— 18
— 20
— 12
— 10

**FIG. 4**

— 14
— 16
n+ — 22
— 10

**FIG. 5**

REMOVE
OVERLAYERS

— 22
n+
— 10

## FIG. 6

## FIG. 7